# FASCICULE DE BREVET EUROPEEN

(11) **EP 1 776 312 B1**
(45) Date de publication et mention de la délivrance du brevet: **04.09.2019**
(21) Numéro de dépôt: 05857326.2
(22) Date de dépôt: 10.08.2005
(51) Int. Cl.: B81B 7/00, B81B 3/00, B81C 1/00

(54) **PROCEDE DE FABRICATION D'UN DISPOSITIF COMPRENANT UN MICROSYSTEME ENCAPSULE**
VERFAHREN ZUR HERSTELLUNG EINER VORRICHTUNG MIT EINEM VERKAPSELTEN MIKROSYSTEM
METHOD OF FABRICATING A DEVICE COMPRISING AN ENCAPSULATED MICROSYSTEM

(30) Priorité: 13.08.2004 FR 0451848
(43) Date de publication de la demande: 25.04.2007
(73) Titulaire: Commissariat à l'Énergie Atomique et aux Énergies Alternatives, 75015 Paris (FR)
(72) Inventeur: GILLOT, Charlotte, F-38500 Voiron (FR); SILLON, Nicolas, F-38600 Fontaine (FR); LAGOUTTE, Emmanuelle, F-38130 Echirolles (FR)
(74) Mandataire: Ahner, Philippe
(86) Numéro de dépôt international: PCT/FR2005/050665
(87) Numéro de publication internationale: WO 2006/092474

(56) Documents cités:
- DE-A1- 10 056 716
- FR-A- 2 849 016
- US-A- 5 504 026
- US-A- 6 012 336
- US-A- 6 087 701
- US-B1- 6 174 820
- US-B1- 6 352 935
- STAHL H ET AL: "Thin film encapsulation of acceleration sensors using polysilicon sacrificial layers", TRANSDUCERS, SOLID-STATE SENSORS, ACTUATORS AND MICROSYSTEMS, 12TH INN ATIONAL CONFERENCE ON, 2003, PISCATAWAY, NJ, USA,IEEE, 8 June 2003 (2003-06-08), pages 1899-1902vol.2, XP032377891, DOI: 10.1109/SENSOR.2003.1217162 ISBN: 978-0-7803-7731-8

## Description

### DOMAINE TECHNIQUE

L'invention se rapporte au domaine des microdispositifs, en particulier des microsystèmes électromécaniques (ou MEMS) qui sont isolés dans des cavités hermétiques.

L'invention concerne notamment un procédé de fabrication d'un tel MEMS permettant d'obtenir un dispositif plan, qui peut donc être utilisé comme support de fabrication. Le procédé selon l'invention permet par ailleurs l'intégration d'autres constituants dans le dispositif.

### ÉTAT DE LA TECHNIQUE ANTÉRIEURE

Les microsystèmes électromécaniques, actionneurs ou capteurs, connaissent un développement croissant. Dans de nombreux cas, le composant actif est de préférence isolé dans une cavité hermétique au gaz et à l'humidité, de manière à, par exemple, limiter son vieillissement ou augmenter la fiabilité des mesures. Il peut être souhaitable également de contrôler l'atmosphère à l'intérieur de la cavité, par exemple par un gaz neutre permettant d'éviter toute réaction chimique, ou de sceller la cavité sous un vide plus ou moins poussé. La création de ces cavités, c'est-à-dire l'encapsulation des microsystèmes (plus connue sous la terminologie anglo-saxonne de « packaging ») est ainsi une clef du développement des microdispositifs.

Le packaging peut être effectué à l'échelle du dispositif, avec positionnement de la puce dans un boîtier hermétique par exemple. Cette option est cependant relativement coûteuse, et limite la miniaturisation des ensembles.

Une autre possibilité en expansion concerne l'encapsulation à l'échelle du substrat. Il est ainsi possible d'utiliser un capot reporté par scellement hermétique autour du microsystème. Une autre option consiste à réaliser une cavité étanche autour du microsystème par des technologies de surface appropriées, option connue sous la dénomination de « packaging couche mince ».

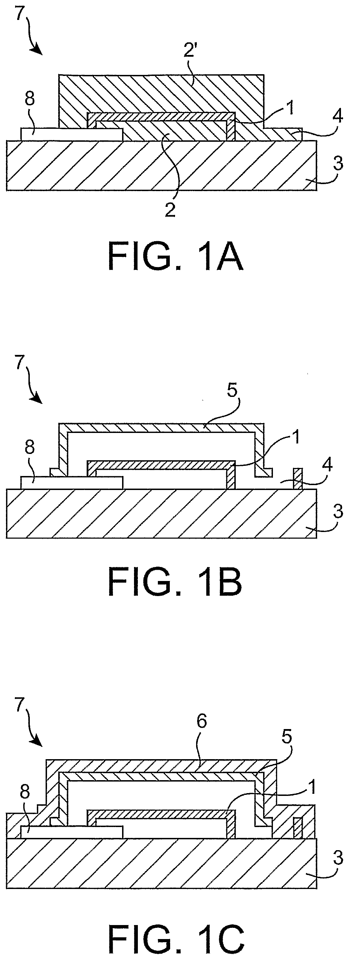

Cette technique est par exemple décrite dans les documents EP-A-0 525 764 ou EP-A-1 101 730, et schématisée dans les figures 1 : un microsystème 1, ici une poutre comprenant un matériau sacrificiel 2 sur une face, est positionné sur un substrat 3, puis un matériau sacrificiel 2' est mis en place pour identifier la cavité et le canal de libération 4 (figure 1A). Ensuite, un matériau d'encapsulation 5 est déposé sur le matériau sacrificiel 2'. Les matériaux sacrificiels 2, 2' sont gravés (figure 1B) pour libérer la poutre. Enfin, un matériau 6 comme SiN est déposé pour boucher la cavité (figure 1C) et former le microdispositif 7.

Cependant, le passage de conducteurs 8, parfois épais (par exemple 1 µm) de l'intérieur du capot 5 vers l'extérieur peut poser des problèmes pour le recouvrement par la couche de bouchage 6 : par exemple, le dépôt par PECVD (« Plasma Enhanced Chemical Vapor Deposition ») n'est pas très couvrant, et le passage de marche est souvent défectueux.

Le principal inconvénient de cette technique reste par ailleurs la forte topologie engendrée par le capot d'encapsulation 5, 6 ainsi créé. Or il peut être intéressant de fabriquer sur le même dispositif 7 des nouveaux composants, par exemple une capacité sur un résonateur radiofréquence. Ceci nécessite une plaque plane, c'est-à-dire un dispositif 7 sans topologie, à savoir un MEMS dit « enterré ».

Le document US 5,504,026 A divulgue un procédé de fabrications d'un dispositif comprenant un microsystème encapsulé dans une cavité d'une première hauteur comprenant la mise en place localement d'un matériau sacrificiel destiné à former au moins la cavité, le dépôt d'une couche sur le support, l'aplanissement de la surface de ladite couche, la cavité étant délimitée par des parois latérales à base de ladite couche et le dépôt d'un capot d'encapsulation.

### EXPOSÉ DE L'INVENTION

L'invention se propose de pallier les inconvénients des techniques existantes. En particulier, l'invention propose une solution pour enterrer un dispositif de type MEMS dans une cavité, notamment hermétique, éventuellement sous vide. L'invention concerne également une technologie qui permet de co-intégrer des autres composants, par exemple des bobines radiofréquence, dans un dispositif dont le microsystème est encapsulé.

Sous un de ses aspects, l'invention concerne un procédé de fabrication comprenant la mise en place de matériau sacrificiel sur un substrat pour délimiter une ou plusieurs cavités, l'encapsulation du matériau sacrificiel par une couche d'épaisseur supérieure à la première hauteur, et la mise à plat, ou aplanissement, connus également sous le terme de « planarisation », de cette couche d'encapsulation qui peut être ensuite recouverte d'une couche de capot d'encapsulation. En particulier, la couche d'encapsulation peut être plus d'une fois et demi plus épaisse que l'épaisseur de matériau sacrificiel, et être composée d'oxyde ou nitrure de silicium, ou d'un bicouche de ces matériaux.

Avantageusement, l'aplanissement de la couche d'encapsulation est accompagné d'un amincissement, en particulier tel que le matériau sacrificiel également est « planarisé » et aminci. L'ensemble est alors recouvert d'un capot d'encapsulation sous forme de couche, avec création préalable par exemple de canaux de matériau sacrificiel pour atteindre les cavités.

De façon préférée, plusieurs cavités sont formées par le matériau sacrificiel, l'une d'entre elles au moins comprenant un microsystème.

Les cavités sont formées par gravure du matériau sacrificiel, qui peut être effectuée de façon successive selon la destination de la cavité. En particulier, une cavité destinée à un système co-intégré peut être libérée préalablement. Il est ensuite possible d'y effectuer une croissance électrolytique, par exemple de cuivre, puis d'aplanir le composé ainsi créé, et de recouvrir l'ensemble d'une couche de passivation.

La cavité comprenant le microsystème peut alors être libérée, puis rebouchée par dépôt d'une couche d'enrobage, avec éventuelle mise sous atmosphère contrôlée.

Sous un autre aspect, la présente demande concerne un microdispositif qui n'est pas revendiqué et qui peut avoir été fabriqué par le procédé décrit précédemment. En particulier, le dispositif est sous forme de plaque, c'est-à-dire qu'il possède une surface plane opposée au substrat, et il comprend une cavité, dont l'atmosphère peut être contrôlée, contenant un microsystème, comme un résonateur. La cavité est délimitée sur ses parois latérales par un matériau, par exemple SiO₂, formant une couche d'épaisseur homogène sur la surface du substrat. De préférence, la paroi de la cavité opposée au substrat est composée d'un matériau formant une autre couche d'épaisseur homogène.

Avantageusement, la couche du matériau formant les parois de la cavité comprend également d'autres composés électroniques constituant le microdispositif, comme des bobines ou des inductances.

### BRÈVE DESCRIPTION DES DESSINS

Les caractéristiques et avantages de l'invention seront mieux compris à la lecture de la description qui va suivre et en référence aux dessins annexés, donnés à titre illustratif et nullement limitatifs.
Les figures 1A-1C, déjà décrites, représentent schématiquement un procédé de fabrication d'un résonateur encapsulé selon l'état de la technique.
Les figures 2A-2E montrent un procédé de fabrication selon l'invention.
Les figures 3A-3D représentent une alternative pour un mode préféré de fabrication d'un dispositif selon l'invention.
La figure 4 représente un autre dispositif qui n'est pas revendiqué.

### EXPOSÉ DÉTAILLÉ DE MODES DE RÉALISATION PARTICULIERS

Le procédé selon l'invention comprend principalement l'enrobage du matériau sacrificiel destiné à former la cavité par une couche épaisse, en particulier d'oxyde, suivi d'un amincissement accompagné d'un aplanissement, par exemple par un procédé CMP, c'est-à-dire en planarisation mécano chimique.

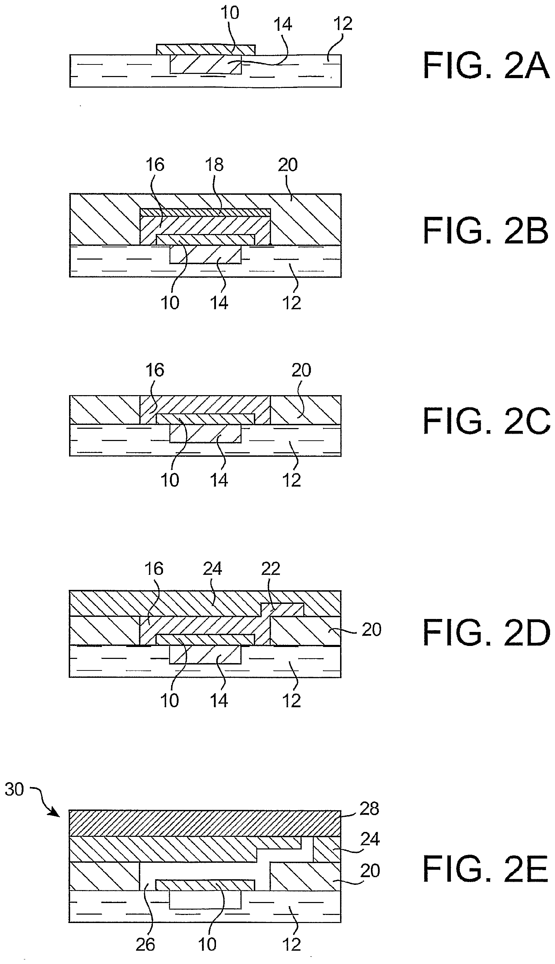

Plus précisément, le procédé selon un mode de réalisation préféré de l'invention peut être décrit en rapport avec les figures 2.

Un microsystème 10, notamment un microsystème électromécanique, est d'abord réalisé sur un support 12, par exemple un substrat en silicium. Comme schématisé sur la figure 2A, le MEMS 10 peut comporter une couche sacrificielle 14 en résine photosensible destinée à libérer les deux faces du MEMS ; il peut s'agir d'un résonateur, par exemple radiofréquence ou « BAW » (c'est-à-dire filtre à onde acoustique de volume), sous forme de poutre ou autre, mais le MEMS peut comprendre tous les composés connus comme des micro capteurs ou des micro actionneurs.

Le substrat 12 peut être monocouche, ou composé d'un empilement de plusieurs couches de matériaux différents ; il peut comporter ou non en surface des composants électroniques (circuits intégrés, inductances). Avantageusement, il présente en surface une face plane (à l'exception des ouvertures nécessaires aux reprises de contact) ; il peut présenter des cavités aux emplacements où sont réalisés les microsystèmes 10.

Le matériau sacrificiel 16 destiné à former la cavité est ensuite mis en place : figure 2B. L'une des possibilités consiste par exemple à déposer une couche de polymère, d'une première épaisseur de 5 µm par exemple, correspondant ou supérieure à la hauteur de la cavité du MEMS 10, sur l'ensemble du substrat 12, puis de la recuire, par exemple à 350°C. Un masque dur 18, par exemple en métal comme le tungstène, est déposé pour recouvrir la cavité, et la couche est gravée, pour ne laisser que le matériau sacrificiel 16 destiné à former la cavité encapsulant le MEMS 10. L'emploi du masque dur 18 n'est cependant pas obligatoire, la couche sacrificielle 16 pouvant, selon le cas, être gravée directement selon des techniques de photolithographie.

La couche d'encapsulation ou d'enrobement 20 est alors mise en place. Avantageusement, l'épaisseur de la couche d'encapsulation 20 est d'environ 1,5 à 1,7 fois celle de la couche de matériau sacrificiel 16. Le dépôt peut être effectué selon les techniques classiques ; il peut être uniforme sur toute l'épaisseur ou composer un bicouche. Avantageusement, la couche d'encapsulation 20 est composée de SiO₂, ou de SiN, ou d'un bicouche SiN/SiO₂, par exemple sur environ 8 µm.

La couche d'encapsulation 20 est ensuite « planarisée », par exemple par un procédé mécano chimique. Cette mise à plat est accompagnée d'un amincissement de la couche d'enrobement 20. Avantageusement, l'amincissement est effectué jusqu'à atteindre la résine sacrificielle 16, le masque 18 étant ainsi supprimé. En variante, l'amincissement peut débuter par un polissage mécano chimique et être poursuivi par une gravure sèche. Cette étape permet en particulier d'atteindre un composé schématisé sur la figure 2C, dont l'épaisseur de matériau sacrificiel 16 est égale à la hauteur de la cavité désirée, et dont la surface opposée au substrat 12 est plane.

De préférence, on procède ensuite à la formation d'un canal destiné à la gravure du matériau sacrificiel 16. A cette fin, une couche mince (par exemple 300 nm) d'un polymère, éventuellement le même que le matériau sacrificiel 16, est déposée, puis recuite à 350°C. Une lithogravure permet de ne garder que le matériau destiné au canal 22. Ce canal 22 facilite le rebouchage ultérieur de la cavité, mais n'est pas obligatoire.

Une deuxième couche d'encapsulation, ou capot, 24 est déposée (figure 2D). Il peut s'agir du même matériau que le premier matériau 20 ; la couche 24 peut faire 1 à 3 µm d'épaisseur, et être composée de SiO₂ ou SiN par exemple.

La cavité du MEMS peut alors être « libérée » : figure 2E. Par exemple, le capot 24 est percé, avantageusement de façon décalée par rapport à la future cavité, et les divers matériaux sacrificiels (du canal 22, de la cavité 16, et du MEMS 14) sont gravés, par plasma oxygène par exemple. La cavité 26 ainsi créée peut être mise sous atmosphère contrôlée (gaz inerte ou vide), et rebouchée par dépôt d'une couche de matériau 28 comme un métal, SiO₂ ou SiN. Ces deux étapes peuvent être effectuées simultanément, le dépôt se faisant à l'atmosphère contrôlée que l'on souhaite obtenir dans la cavité.

Le microdispositif 30 comprend ainsi un substrat 12, une couche d'un premier matériau 20 dont la surface opposée au substrat 12 est plane. Une cavité hermétique 26 comprend un MEMS 10 ; elle est délimitée sur le fond par le substrat 12 et/ou le MEMS 10, latéralement par des parois latérales en premier matériau 20 et au sommet par une paroi sommet composée soit du premier matériau 20, soit d'un deuxième matériau qui forme une couche 24 sur la surface plane du premier matériau 20.

Le microsystème 10 est encapsulé dans le dispositif 30, et la topologie de ce dernier est nulle, c'est-à-dire que le dispositif 30 est plan (sa surface d'encapsulation est parallèle au substrat 12). Cet aspect est conservé même si des conducteurs (voir figure 1) sont présents : ces derniers sont noyés dans la couche épaisse 20, et ne peuvent perturber la fermeture du dispositif 30, ni la mise en place du capot 24, 28. Il est ainsi possible d'utiliser le dispositif 30 en tant par exemple que substrat dans d'autres procédés microélectroniques.

Par ailleurs, on peut aussi positionner d'autres composés microélectroniques dans le dispositif 30 ; la fabrication de ces autres structures peut être effectuée avant la libération de la cavité 26, c'est-à-dire alors que le MEMS 10 est protégé par la résine sacrificielle 14, 16. En particulier, il est possible d'intégrer d'autres structures lors la fabrication du dispositif 30 ; il devient ainsi possible de co-intégrer des inductances ou des pistes électriques épaisses, ce qui est particulièrement avantageux lorsque le MEMS 10 encapsulé est un dispositif radiofréquence, de type interrupteur, inductance variable ou résonateur.

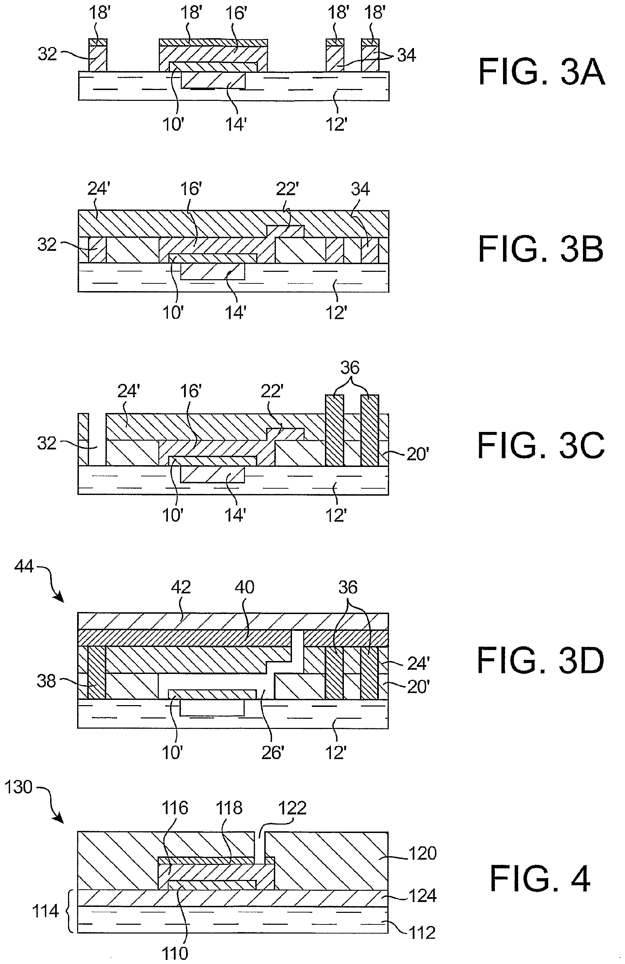

L'un des procédés préférés pour cette co-intégration est décrit en référence aux figures 3.

Le MEMS 10' est positionné sur le substrat 12', la couche sacrificielle 16' peut être déposée de façon similaire au procédé décrit dans la figure 2. Cependant, dans le procédé décrit ici, le masque dur 18' est plural, de sorte que la gravure de la couche sacrificielle 16' laisse subsister différentes zones schématisées en figure 3A : une partie de la couche sacrificielle 16' est destinée à former la cavité à atmosphère contrôlée autour du MEMS 10', mais la résine définit également des deuxièmes cavités 32, 34 destinées par exemple à mettre en place des conducteurs épais et/ou des inductances. Il est bien sûr possible d'avoir plusieurs cavités 26' destinées à des MEMS 10' identiques ou différents.

Bien que la réalisation des deuxièmes zones sacrificielles 32, 34 puisse être faite dans la même couche de matériau sacrificiel 16', il est clair qu'il est possible également de procéder à plusieurs mises en place successives de façon à obtenir des régions de natures différentes.

Le procédé est ensuite poursuivi comme précédemment jusque l'étape de la figure 2D par exemple : le dispositif de la figure 3B comprend un substrat 12' sur lequel est positionné un MEMS 10' dans une cavité remplie de matériau sacrificiel 16'. Sur le substrat 12' se trouve une couche de matériau d'encapsulation 20' plane traversée de zones 16', 32, 34 de matériau sacrificiel. L'ensemble est recouvert d'un capot d'encapsulation 24' dans lequel est positionné un canal 22' de matériau sacrificiel.

Il est possible à ce stade d'ouvrir préférentiellement les deuxièmes cavités 32, 34, et d'en graver le matériau sacrificiel tout en maintenant la cavité du MEMS dans son état rempli de matériau sacrificiel 16'. Les deuxièmes cavités 32, 34 peuvent alors être pourvues de leurs composés électroniques (figure 3C). Par exemple, il est possible de procéder à une croissance électrolytique 36 de métal, comme le cuivre, pour former une bobine, ou de déposer un matériau afin de former un conducteur épais. Ces étapes peuvent être simultanées ou séquentielles suivant la nature du composé à mettre en place et concernent toutes les techniques usuelles de mise en place et/ou fabrication.

Une fois les cavités 32, 34 pourvues de leur composé 36, 38, un nouvel aplanissement est effectué, par exemple par procédé CMP. Puis, la surface est passivée 40, en particulier sur les conducteurs 38 et les inductances 36, par exemple par dépôt de SiO₂.

Le procédé peut ensuite être poursuivi comme précédemment en ce qui concerne la mise sous atmosphère contrôlée de la cavité entourant le MEMS 10' : perçage de l'ensemble couche de passivation 40 et capot 24', gravure de la résine 14', 16', bouchage par dépôt d'une couche 42.

Le dispositif 44 de la figure 3D présente ainsi un MEMS 30' enterré ainsi que des composés 36, 38 intégrés, et il est sous forme de plaque plane. Grâce au procédé selon l'invention, le nombre d'étapes pour fabriquer le dispositif 44 de topologie nulle a été réduit par rapport aux procédés existants. De plus, la compatibilité entre les étapes de fabrication de chacun des composants ne pose plus aucun problème, ce qui allège d'autant le procédé et ouvre des perspectives d'associations de divers MEMS.

L'invention s'applique plus particulièrement à la fabrication de microsystèmes électromécaniques radiofréquence, ainsi qu'à la fabrication de micro-capteurs et micro-actionneurs. De plus, la fabrication d' autres alternatives classiques de ce genre de dispositif est comprise dans l'invention.

Par exemple, bien que décrit avec un microsystème 10 positionné directement sur le substrat 12, il faut comprendre que le dispositif 130 peut être tel que le microsystème 110 est positionné sur tout support 114 usuel, comme sur un substrat 112 qui a été préparé, par exemple revêtu préalablement d'une couche d'oxyde 124, similaire éventuellement à la couche d'encapsulation 120 : voir figure 4.

De même, une autre possibilité, qui n'est pas revendiquée, est que l'amincissement débouche sur le matériau sacrificiel 116 ; on prévoira dans ce cas dans le matériau d'encapsulation 120 (et le masque 118 s'il existe) un canal 122 pour permettre l'élimination du matériau sacrificiel. Le masque 118 peut ne pas avoir été détruit lors de l'aplanissement de la couche d'encapsulation 120, et un trou peut le traverser pour supprimer le matériau sacrificiel 116. Ce trou pourra être rebouché après suppression du matériau sacrificiel 116 si l'on souhaite contrôler l'atmosphère de la cavité.

## Revendications

1. Procédé de fabrication d'un dispositif (30, 44, 130) comprenant un microsystème (10) réalisé sur un support (12) et encapsulé dans une cavité (26) d'une première hauteur, le dispositif étant plan au niveau de sa surface d'encapsulation, cette surface d'encapsulation étant une surface opposée et parallèle au support, le procédé comprenant :
- la fourniture du microsystème (10) sur le support (12) ;
- la mise en place localement d'un matériau sacrificiel (16) destiné à former au moins la cavité (26) ;
- le dépôt d'une couche d'encapsulation (20, 120) sur le support (12) et le matériau sacrificiel (16) ;
- l'aplanissement de la surface de la couche d'encapsulation (20) opposée au support (12), l'aplanissement étant accompagné d'un amincissement de la couche d'encapsulation (20) jusqu'à atteindre le matériau sacrificiel (16) ou bien étant un amincissement de la couche d'encapsulation (20) et du matériau sacrificiel (16) et effectué de telle sorte que le matériau sacrificiel est également aplani,
le procédé comprenant après amincissement de la couche d'encapsulation (20), le dépôt d'un capot (24) d'encapsulation, ledit capot (24) étant formé sur la surface plane de la couche d'encapsulation (20) et ayant une surface opposée au substrat (12) qui est plane.

2. Procédé selon la revendication 1 dans lequel l'amincissement est suivi de la mise en place d'une deuxième structure de canal d'un deuxième matériau sacrificiel vers le matériau sacrificiel (16) destiné à former la cavité, le capot d'encapsulation (24) étant déposé de manière à avoir une épaisseur supérieure à celle du canal (22) de façon à avoir une surface plane.

3. Procédé selon l'une des revendications 1 ou 2, dans lequel le capot d'encapsulation (24) est de même nature que la couche d'encapsulation (20).

4. Procédé selon l'une des revendications 1 à 3 dans lequel la mise en place du matériau sacrificiel (16) se fait par dépôt d'une couche de matériau sacrificiel d'une première épaisseur au moins égale à la première hauteur de la cavité (26) et gravure du matériau sacrificiel (16).

5. Procédé selon la revendication 4 comprenant la mise en place d'un masque (18) sur le matériau sacrificiel (16) avant sa gravure.

6. Procédé selon l'une des revendications 1 à 5 dans lequel la couche d'encapsulation (20) est réalisée avec une épaisseur supérieure ou égale à une fois et demie l'épaisseur du matériau sacrificiel (16).

7. Procédé selon l'une des revendications 1 à 6, dans lequel la couche d'encapsulation (20) est composée de SiO₂, SiN ou d'un bicouche SiO₂/SiN.

8. Procédé selon l'une des revendications 1 à 7 dans lequel le matériau sacrificiel (16) mis en place est destiné à former en outre au moins une deuxième cavité (32, 34).

9. Procédé selon la revendication 8 suivi de la gravure du matériau sacrificiel des deuxièmes cavités (32, 34).

10. Procédé selon la revendication 9 suivi de la mise en place d'éléments microélectroniques (36, 38) dans les deuxièmes cavités (32, 34).

11. Procédé selon la revendication 10 dans lequel la mise en place d'au moins un élément microélectronique (36) s'effectue par croissance électrolytique de métal dans une deuxième cavité (34).

12. Procédé selon l'une des revendications 10 ou 11 comprenant l'aplanissement de la surface du dispositif formé opposée au support (12).

13. Procédé selon la revendication 12 suivi du dépôt d'une couche de passivation (40).

14. Procédé selon l'une des revendications 1 à 13, suivi de la gravure du matériau sacrificiel destiné à la cavité, suivi de la mise sous atmosphère contrôlée de la cavité (26).

15. Procédé selon l'une des revendications 1 à 14 comprenant en outre l'étape de dépôt d'un matériau (28, 42) pour boucher la cavité (26).

16. Procédé selon la revendication 15 dans lequel la mise sous atmosphère contrôlée de la cavité (26) est simultanée avec le dépôt d'un matériau (28, 42) pour boucher la cavité (26).

## Patentansprüche

1. Verfahren zum Herstellen einer Vorrichtung (30, 44, 130) mit einem Mikrosystem (10), das an einem Träger (12) ausgebildet und in einem Hohlraum (26) mit einer ersten Höhe eingekapselt ist, wobei die Vorrichtung im Bereich ihrer Einkapselungsfläche eben ist, wobei diese Einkapselungsfläche eine dem Träger entgegengesetzte und parallel dazu verlaufende Fläche ist, wobei das Verfahren umfasst:
- Bereitstellen des Mikrosystems (10) an dem Träger (12);
- bereichsweises Aufbringen eines Opfermaterials (16), das dazu bestimmt ist, zumindest den Hohlraum (26) zu bilden;
- Abscheiden einer Einkapselungsschicht (20, 120) auf den Träger (12) und das Opfermaterial (16);
- Planarisieren der dem Träger (12) entgegengesetzten Fläche der Einkapselungsschicht (20), wobei das Planarisieren mit einem Verjüngen der Einkapselungsschicht (20) bis zum Erreichen des Opfermaterials (16) einhergeht oder ein Verjüngen der Einkapselungsschicht (20) und des Opfermaterials (16) ist und so erfolgt, dass das Opfermaterial auch planarisiert wird,
wobei das Verfahren nach dem Verjüngen der Einkapselungsschicht (20) das Abscheiden einer Einkapselungsdecke (24) umfasst, wobei die Decke (24) aus der ebenen Fläche der Einkapselungsschicht (20) gebildet ist und eine dem Substrat (12) entgegengesetzte, ebene Fläche hat.

2. Verfahren nach Anspruch 1, wobei dem Verjüngen das Aufbringen einer Kanalstruktur aus einem zweiten Opfermaterial (22) in Richtung Opfermaterial (16) folgt, das dazu bestimmt ist, den Hohlraum zu bilden, wobei die Einkapselungsdecke (24) so abgeschieden wird, dass sie eine größere Dicke als der Kanal (22) aufweist, so dass eine ebene Fläche vorliegt.

3. Verfahren nach einem der Ansprüche 1 oder 2, wobei die Einkapselungsdecke (24) von gleicher Beschaffenheit wie die Einkapselungsschicht (20) ist.

4. Verfahren nach einem der Ansprüche 1 bis 3, wobei das Aufbringen des Opfermaterials (16) durch Abscheiden einer Opfermaterialschicht mit einer ersten Dicke, die zumindest gleich der ersten Höhe des Hohlraums (26) ist, und durch Ätzen des Opfermaterials (16) erfolgt.

5. Verfahren nach Anspruch 4, umfassend das Aufbringen einer Maske (18) auf das Opfermaterial (16) vor dessen Ätzen.

6. Verfahren nach einem der Ansprüche 1 bis 5, wobei die Einkapselungsschicht (20) mit einer Dicke erfolgt, die größer oder gleich anderthalbmal die Dicke des Opfermaterials (16) ist.

7. Verfahren nach einem der Ansprüche 1 bis 6, wobei die Einkapselungsschicht (20) aus SiO₂, SiN oder einer Doppelschicht SiO₂/SiN besteht.

8. Verfahren nach einem der Ansprüche 1 bis 7, wobei das aufgebrachte Opfermaterial (16) dazu bestimmt ist, ferner zumindest einen zweiten Hohlraum (32, 34) zu bilden.

9. Verfahren nach Anspruch 8, gefolgt von dem Ätzen des Opfermaterials der zweiten Hohlräume (32, 34).

10. Verfahren nach Anspruch 9, gefolgt von dem Einbringen von mikroelektronischen Elementen (36, 38) in die zweiten Hohlräume (32, 34).

11. Verfahren nach Anspruch 10, wobei das Einbringen zumindest eines mikroelektronischen Elements (36) durch elektrolytisches Wachsen von Metall in einem zweiten Hohlraum (34) erfolgt.

12. Verfahren nach einem der Ansprüche 10 oder 11, umfassend das Planarisieren der dem Träger (12) entgegengesetzten Fläche der gebildeten Vorrichtung.

13. Verfahren nach Anspruch 12, gefolgt von dem Abscheiden einer Passivierungsschicht (40).

14. Verfahren nach einem der Ansprüche 1 bis 13, gefolgt von dem Ätzen des Opfermaterials für den zweiten Hohlraum, gefolgt von dem Aussetzen des Hohlraums (26) einer kontrollierten Atmosphäre.

15. Verfahren nach einem der Ansprüche 1 bis 14, ferner umfassend den Schritt des Abscheidens eines Materials (28, 42) zum Verschließen des Hohlraums (26).

16. Verfahren nach Anspruch 15, wobei das Aussetzen des Hohlraums (26) einer kontrollierten Atmosphäre gleichzeitig mit dem Abscheiden eines Materials (28, 42) zum Verschließen des Hohlraums (26) erfolgt.

## Claims

1. Process for manufacturing a device (30, 40,130) comprising a microsystem (10), made on a support (12) and packaged in a cavity (26) with a first height, the device being plane at its packaging surface, this packaging surface being a surface opposite and parallel to the support, the process comprising:
- supply of the microsystem (10) on the support (12),
- local positioning of a sacrificial material (16) that is intended to form at least the cavity (26),
- deposition of a packaging layer (20,120) onto the support (12) and the sacrificial material (16),
- planarisation of the surface of the packaging layer (20) opposite to the support (12), this planarisation being accompanied by thinning of the packaging layer (20) until the sacrificial material (16) is reached, or being a thinning of the packaging layer (20) and the sacrificial material (16) and performed so that the sacrificial material is also planarised,
- said process comprising after thinning of the packaging layer (20) the deposition of a packaging cap (24), said cap (24) being formed on the planarised surface of the packaging layer (20) and having a planar surface opposed to the substrate (12).

2. Process as in claim 1, in which thinning is followed by placing a channel structure of a second sacrificial material (22) towards the sacrificial material (16) intended to form the cavity, the packaging cap (24) being deposited so as to be thicker than the channel (22) so as to have a plane surface.

3. Process as in one of claims 1 or 2, in which the packaging cap (24) is of the same nature as the packaging layer (20).

4. Process as in any of claims 1 to 3, in which the sacrificial material (16) is placed by depositing a layer of sacrificial material with a first thickness at least equal to the first height of the cavity (26) followed by etching of the sacrificial material (16).

5. Process as in claim 4, including placing a mask (18) on the sacrificial material (16) before etching it.

6. Process as in any of claims 1 to 5, in which the thickness of the packaging layer (20) is at least one and a half times the thickness of the sacrificial material (16).

7. Process as in any of claims 1 to 6, in which the packaging layer (20) is composed of SiO₂, SiN, or an SiO₂/SiN bi-layer.

8. Process as in any of claims 1 to 7, in which the sacrificial material (16) put into place is also intended to form at least one second cavity (32, 34) .

9. Process as in claim 9, followed by etching of the sacrificial material of the second cavities (32, 34).

10. Process as in claim 9, followed by placement of microelectronic elements (36, 38) in the second cavities (32, 34).

11. Process as claim 10, in which at least one microelectronic element (36) is put into place by electrolytic growth of metal in a second cavity (34).

12. Process as in any of claims 10 or 11, including planarisation of the surface of the device formed opposite to the support (12).

13. Process as in claim 12, followed by deposition of a passivation layer (40).

14. Process as in any of claims 1 to 13, followed by etching of the sacrificial material intended for the cavity, followed by putting the cavity (26) under a controlled atmosphere.

15. Process as in any of claims 1 to 14, also including the step to deposit a material (28, 42) to close off the cavity (26).

16. Process as in claim 15, in which the cavity (26) is put under a controlled atmosphere simultaneously with deposition of a material (28, 42) to close off the cavity (26).
